# EUROPEAN PATENT APPLICATION

(11) **EP 3 176 811 A1**
(43) Date of publication of application: **07.06.2017**
(21) Application number: 15826446.5
(22) Date of filing: 29.07.2015
(51) Int. Cl.: H01L 21/312, H01L 21/768, H01L 23/532

(54) **SACRIFICIAL FILM COMPOSITION, METHOD FOR PREPARING SAME, SEMICONDUCTOR DEVICE HAVING VOIDS FORMED USING SAID COMPOSITION, AND METHOD FOR MANUFACTURING SEMICONDUCTOR DEVICE USING SAID COMPOSITION**

(30) Priority: 31.07.2014 JP 2014156728
(71) Applicant: AZ Electronic Materials Luxembourg S.à.r.l., 1648 Luxembourg (LU)
(72) Inventor: NAKASUGI Shigemasa, Kakegawa-shi Shizuoka 437-1412 (JP); KINUTA Takafumi, Kakegawa-shi Shizuoka 437-1412 (JP); NOYA Go, Kakegawa-shi Shizuoka 437-1412 (JP); YANAGITA Hiroshi, Kakegawa-shi Shizuoka 437-1412 (JP); HAMA Yusuke, Kakegawa-shi Shizuoka 437-1412 (JP)
(74) Representative: Rippel, Hans Christoph
(86) International application number: PCT/JP2015/071476
(87) International publication number: WO 2016/017678

(57) **Abstract**

[Problem]

To provide such a composition for producing a sacrifice layer as has excellent properties in both heat resistance and storage stability, and also to provide a process for producing a semiconductor device using the composition.

[Solution]

Disclosed is a composition for producing a sacrifice layer. The composition comprises a solvent and a polymer having a repeating unit containing a nitrogen atom with a lone pair, and contains particular transition metals only in a very low content. Also disclosed is a process using the composition as a sacrificial material for producing a semiconductor device comprising a porous material.

## Description

### TECHNICAL FIELD

The present invention relates to such a composition for producing a sacrifice layer as can easily form air gaps among metal wirings in semiconductor elements and the like, and also relates to a method in which the composition is used to form air gaps among the metal wirings.

### BACKGROUND ART

Silica (SiO₂) films formed by vacuum processes such as CVD method have hitherto been often adopted as interlayer dielectrics in semiconductor elements and the like. Further, SOG (spin-on-glass) films, which are wet-coating type insulating films principally made of tetraalkoxysilane hydrolysate, are also employed mainly for the purpose of planarization. Recently, as semiconductor elements and the like have been getting more integrated, demands to interlayer dielectrics of low permittivity have increasingly grown in expectation of reducing stray capacity among the wirings and thereby of improving wire delay. As a means for reducing stray capacity among the wirings, semiconductor devices disclosed in Patent documents 1, 2 and 3 contain air gaps formed among the wirings. Those documents disclose a method comprising the steps of: filling spaces among the wirings with an organic resist or a silica compound; and then removing the organic resist or the silica compound by etching or ashing to form gaps among the wirings. However, that method has a problem of requiring complicated operations. In order to avoid the complicated operations, Patent documents 4, 5 and 6 disclose sacrificial materials as examples of substances capable of easily forming air gaps among the wirings.

However, conventionally known sacrificial materials or compositions containing them for producing sacrifice layers are often poor in storage stability. If the compositions have poor storage stability, fine particles may be formed therein with the passage of time and may affect resultant semiconductor devices and the like. Further, some defects are likely to be formed in coating films produced by application of the compositions. Those defects generally increase with increasing storage time of the compositions, and this increase of defects is very large if the compositions are poor in storage stability. The present inventors have studied and found that compositions for producing sacrifice layers are apt to be poor in storage stability if they comprise nitrogen-containing polymers. Although research has been made on compositions without nitrogen-containing polymers, they are often poor in heat resistance. This means that the storage stability and heat resistance are in a trade-off relationship, and hence it has been desired to provide such a composition for gap formation as can solve the dilemma comprehensively.

### PRIOR ART DOCUMENTS

### PATENT DOCUMENTS

[Patent document 1] Japanese Patent Laid-Open No. H9(1997)-172068
[Patent document 2] Japanese Patent Laid-Open No. H8(1996)-83839
[Patent document 3] Japanese Patent Laid-Open No. 2001-85519
[Patent document 4] Japanese Patent Laid-Open No. 2003-342375
[Patent document 5] Japanese Patent Laid-Open No. 2004-63749
[Patent document 6] Japanese Patent Laid-Open No. 2009-275228

### DISCLOSURE OF INVENTION

### PROBLEM TO BE SOLVED BY THE INVENTION

The present invention is achieved in consideration of the above background, and hence aims to provide a composition having excellent properties for producing a sacrifice layer among multilayer wirings.

### MEANS FOR SOLVING PROBLEM

The composition for producing a sacrifice layer according to the present invention comprises a solvent and a polymer having a repeating unit containing a nitrogen atom with a lone pair, wherein said composition contains transition metals in a total content of 3.0 ppb or less.

The process for producing the composition for producing a sacrifice layer according to the present invention comprises:
preparing a solution by mixing a solvent and a polymer having a repeating unit containing a nitrogen atom with a lone pair and dissolving said polymer in the solvent, and
removing transition metal ions from the solution so that the total content of transition metals is 3.0 ppb or less.

Further, the process for producing a semiconductor device according to the present invention is for the purpose of producing a semiconductor device comprising a porous material containing plural air gaps, and it comprises:
applying said porous material with the above composition for producing a sacrifice layer, so that said air gaps are filled with said composition,
vaporizing a part or all of the solvent in said composition to form sacrifice areas made of a sacrificial material,
forming grooves on the surface of said porous material,
filling said grooves with a metal material so as to form metal wirings, and
removing said sacrificial material selectively so as to convert said sacrifice areas back into hollow gaps.

Furthermore, the semiconductor device according to the present invention is characterized by being produced by the above process.

### EFFECT OF THE INVENTION

According to the present invention, the composition for producing a sacrifice layer can be stably stored for long time because fine particles formed therein and defects formed in coating films produced therefrom are prevented from increasing with the storage period.

### BRIEF DESCRIPTION OF THE DRAWINGS

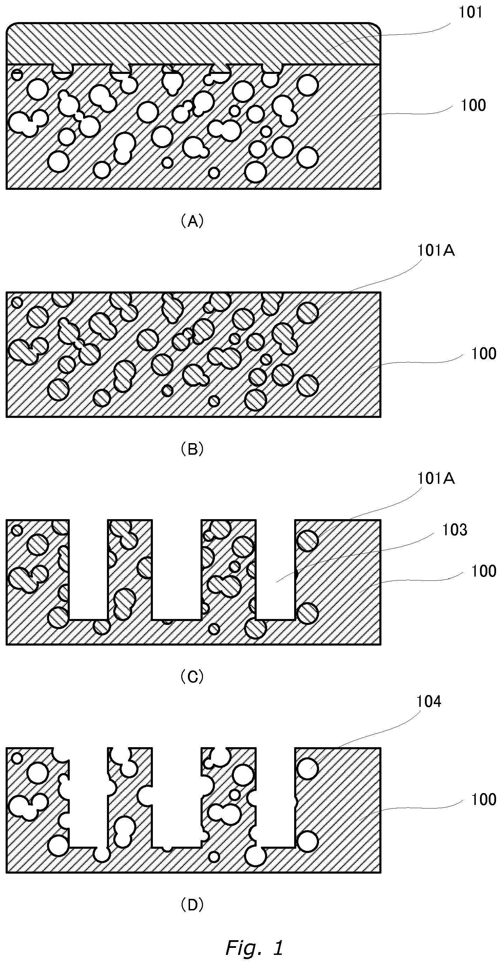

[Figure 1] Figure 1 shows schematic sectional views illustrating a part of the process for producing a semiconductor device according to an embodiment of the present invention.

### DETAILED DESCRIPTION

### [composition for producing a sacrifice layer]

The present invention relates to a composition for producing a sacrifice layer. Here, the "composition for producing a sacrifice layer" means a composition for forming gaps among metal wirings and the like on a substrate or a composition for protecting or keeping gaps pre-existing there, for example, in a process for producing a semiconductor device. Specifically, the composition has the properties of being capable of filling gaps or pores on the substrate surface, of being thereafter stable below a particular temperature, and of being easily removable by vaporization above a particular temperature.

The composition for producing a sacrifice layer according to the present invention comprises a solvent and a polymer having a repeating unit containing a nitrogen atom with a lone pair. The nitrogen atom with a lone pair can be included in various forms in the polymer, but preferably included in a primary or secondary amino group or in an imino group in the polymer. Although a cyano group also includes a lone pair, it is difficult for the group to form a coordinate bond. Accordingly, it is difficult for a cyano group to form a bond with a metal ion as described later, and hence the effect of the present invention tends to appear remarkably when the polymer containing an amino or imino group is adopted rather than that containing a cyano group. The former polymer is thus preferred to the latter.

The repeating unit can be freely selected. For example, it can be selected from those represented by the following formulas (1) to (4). Each of the repeating units of (1) to (3) contains a nitrogen atom in the main chain while that of (4) contains a nitrogen atom in the side chain.

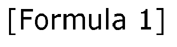

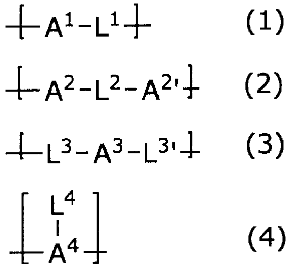

In the above formulas, each of L¹, L², L³, L³ and L⁴ is a group including a nitrogen atom with a lone pair, and each of A¹, A², A^{2'}, A³ and A⁴ is a linking group. Those groups will be described below in detail.

Each of A¹, A², A^{2'}, A³ and A⁴ is independently an aromatic group or a saturated or unsaturated aliphatic hydrocarbon group. The aliphatic hydrocarbon group may have a straight-chain, branched chain or cyclic structure. The above aromatic group or aliphatic hydrocarbon group may be substituted with a substituent selected from the group consisting of hydroxyl, alkyl, aryl, alkoxy, nitro, amide, dialkylamino, sulfonamide, imide, carboxy, sulfonic ester, alkylamino and arylamino. There are no particular restrictions on the size of the group. However, if it is too large, the molecule contains the nitrogen atoms in such a small ratio that the heat resistance tends to be lowered. Accordingly, each of A¹, A², A^{2'}, A³ and A⁴ preferably comprises 1 to 12 carbon atoms.

Each of L¹, L², L³ and L^{3'} is preferably independently selected from the following formulas (a1) to (a3):

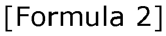

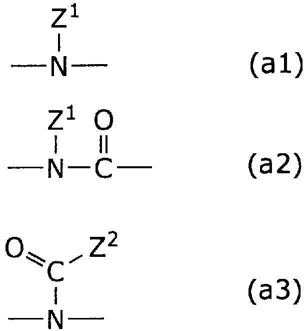

In the above formulas,
Z¹ is selected from the group consisting of hydrogen, an aliphatic group and an aromatic group, provided that the aliphatic or aromatic group is selected from the group consisting of alkyl, aryl, alkoxy, nitro, amide, dialkylamino, sulfonamide, imide, carboxy, sulfonic ester, alkylamino and arylamino; and
Z² is selected from the group consisting of hydrogen, hydroxyl, an aliphatic group and an aromatic group, provided that the aliphatic or aromatic group is selected from the group consisting of alkyl, aryl, alkoxy, nitro, amide, dialkylamino, sulfonamide, imide, carboxy, sulfonic ester, alkylamino and arylamino.

In view of the heat resistance and the like, the number of carbon atoms contained in Z¹ or Z² is preferably 6 or less.

Further, L⁴ is selected from the group consisting of amino group (-NH₂), carbamoyl group (-(C=O)-NH₂), and substituted aromatic and aliphatic groups having them as substituents. Specifically, A⁴ may be directly linked to an amino or carbamoyl group, but A⁴ may connect to an aliphatic group having 1 to 12 carbon atoms or an aromatic group having 6 to 12 carbon atoms provided that the aliphatic or aromatic group is combined with an amino or carbamoyl group. In the amino or carbamoyl group, a hydrogen atom may be replaced with an aromatic or aliphatic group.

The polymer having the above repeating unit can have various structures. For example, it can have the structures described below.

In an example of the polymer, each of the above A¹, A² and A^{2'} is independently selected from the group consisting of phenylene and naphthylene groups, and the above Z¹ is selected from the group consisting of hydrogen, phenylene and naphthylene groups. This polymer contains an aromatic group in the main chain, and has such high heat resistance as to exhibit excellent thermal stability at about 400°C. Further, the polymer is also characterized in that it can be easily processed when used in the composition for producing a sacrifice layer.

In another example of the polymer, each of the above A¹, A² and A^{2'} is independently selected from the group consisting of an alkylene group having 1 to 6 carbon atoms and an alkenylene group having 2 to 6 carbon atoms, and each of the above Z¹ and Z² is independently selected from the group consisting of hydrogen, an alkyl group having 1 to 10 carbon atoms, a cycloalkyl group having 3 to 10 carbon atoms, an alkenyl group having 2 to 10 carbon atoms, a cycloalkenyl group having 3 to 10 carbon atoms, an aryl group having 6 to 10 carbon atoms, and a cyclic amine group having 2 to 5 carbon atoms. This polymer contains an aromatic group in the main chain, and is preferably used in the composition for producing a sacrifice layer because it can be easily decomposed and vaporized in a short time at a particular temperature.

In still another example of the polymer, the above A⁴ is selected from the group consisting of a saturated hydrocarbon group having 1 to 6 carbon atoms and an unsaturated hydrocarbon group having 2 to 6 carbon atoms, and the above L⁴ is selected from the group consisting of a saturated or unsaturated amino group, a saturated or unsaturated carbamoyl group, and a hydrocarbon group substituted therewith. This polymer is also preferably employed.

In yet still another example of the polymer, the above A³ is selected from the group consisting of a saturated hydrocarbon group having 1 to 12 carbon atoms and an unsaturated hydrocarbon group having 2 to 12 carbon atoms, and the above L³ is selected from the group consisting of -(NH)- and -(NH)-(C=O)-. This polymer is still also preferably adopted.

The polymer used in the present invention has the above repeating unit, and may have two or more kinds thereof. In addition, the polymer may have repeating units other than the above as long as they do not impair the effect of the present invention. If comprising two or more kinds of the repeating units, the polymer may be either a random copolymer containing the repeating units at random or a block copolymer containing blocks of the repeating units. Further, the two or more kinds of the repeating units may be arranged regularly. For example, if a monomer having two amino groups at the terminals (i.e., a monomer corresponding to the formula (3)) is made to react with a monomer having two carboxy groups, the obtained polymer comprises two kinds of the repeating units that are arranged regularly and alternatively. This polymer is preferably employable in the present invention.

The polymer used in the present invention can be controlled to have any molecular weight according to the purpose. However, the weight average molecular weight Mw is preferably 1000 to 1000000, more preferably 3000 to 500000. Here, the "weight average molecular weight" means weight average molecular weight in terms of polystyrene in the present invention. In view of the permeability in application of the composition and of the uniformity of the formed film, the polymer preferably has a narrow distribution of molecular weight.

The composition of the present invention for producing a sacrifice layer also contains a solvent, which needs to be capable of dissolving the above polymer.

Examples of the solvent include: water, ethanol, isopropanol (IPA), ethyl lactate (EL), propyleneglycol monomethyl ether acetate (PGMEA), propyleneglycol monomethyl ether (PGME), acetone, methyl isobutyl ketone (MIBK), methyl isobutyl carbinol (MIBC), methyl amyl ketone (MAK), tetrahydrofuran (THF), γ-butyrolactone (GBL), N-methylpyrrolidone (NMP), dimethylacetamide (DMAC), cyclohexanone, chlorobenzene, chloroform, acetonitrile, toluene, and anisole. Among them, solvents preferred in view of the dissolving ability are THF, GBL, NMP, DMAC, cyclohexanone, chlorobenzene, chloroform, toluene and anisole. On the other hand, in view of the coating properties, THF, GBL, cyclohexanone, chlorobenzene, toluene and anisole are preferred. Further, if necessary, those may be used in combination of two or more. For example, mixed solvents of THF, GBL, NMP, DMAC, cyclohexanone and chlorobenzene are preferred in view of the storage stability.

According to the present invention, the composition for producing a sacrifice layer requires to contain the aforementioned polymer and solvent. The content of the polymer in the composition is appropriately controlled according to the sizes of the aimed gaps and the viscosity of the composition, but is generally 0.2 to 20 wt%, preferably 0.3 to 10 wt%, more preferably 0.5 to 5 wt%, based on the total weight of the composition.

If necessary, the composition of the present invention for producing a sacrifice layer can further contain other components, such as, a surfactant, a smoothing agent, and a germicide. Among them, the composition preferably contains a surfactant in view of the coating properties. As the surfactant, any known one can be used but an alkylene glycol chain-containing one is particularly preferred. Those additives essentially give no effect to the performance of the fine pattern-forming composition, and are contained in an amount of generally 1% or less, preferably 0.1% or less, more preferably 0.05% or less, based on the total weight of the composition.

In the present invention, the composition for producing a sacrifice layer is required to penetrate into narrow trenches and small pores. Accordingly, the viscosity thereof is often an important factor of the invention and hence is appropriately controlled according to the purpose. However, in order to make the composition penetrate into the pores, the composition applied to the substrate can be placed under such a high temperature environment that the viscosity is reduced enough for the composition to penetrate into the pores. In this way, even if having a relatively high viscosity at room temperature, the composition can be made to sufficiently penetrate into the pores.

As one of the characteristics of the composition for producing a sacrifice layer according to the present invention, it contains a very small content of transition metals, particularly, certain transition metal ions as impurities. Specifically, the composition of the present invention contains transition metals in a total content of 3.0 ppb or less, preferably 2.8 ppb or less. There are many kinds of transition metals, but those requiring to be heeded are iron, copper, vanadium, nickel, palladium and zinc. As described later, they are included in a catalyst useful for synthesizing the polymer employed in the composition of the present invention, and are therefore likely to get into the composition together with the polymer. Accordingly, from a practical viewpoint, the composition contains iron, copper, vanadium, nickel, palladium and zinc in a total content of 3.0 ppb or less, preferably 2.8 ppb or less. Transition metals other than iron, copper, vanadium, nickel, palladium and zinc are normally negligible because they hardly get into the polymer materials or the composition in the production process. In addition, as described later, when iron, copper, vanadium, nickel, palladium and zinc are removed from the composition, other transition metals are generally removed at the same time. Consequently, the contents of other transition metals are also made to be very low. There are no particular restrictions on the method for producing such a composition for producing a sacrifice layer as contains transition metal ions in a small content. However, it can be generally produced in a manner where the above-described solvent and the above-described polymer having the repeating unit containing a nitrogen atom with a lone pair are mixed and dissolved to prepare a solution, from which transition metal ions are then removed. There are no particular restrictions on the process for removing the metal ions. For example, the polymer is dissolved in a solvent, and then the metal ions are removed therefrom with an ion-exchange resin. The metal ions may be removed by use of activated alumina adsorption, by use of an acidic aqueous solution or by use of a layered clay mineral. In view of the metal removal efficiency and of the recovery ratio, the metal ions are preferably removed with an ion-exchange resin. In that case, there are no particular restrictions on the kind of ion-exchange resin. Examples of the ion-exchange resin include: a strongly acidic cation-exchange resin having sulfonic acid group as a functional group, a strongly basic anion-exchange resin having tertiary ammonium group as a functional group, and a cation-exchange resin obtained by graft polymerization of ion-exchange groups with a porous film made of polyethylene. In consideration of the purpose of removing transition metal ions such as iron, copper, vanadium, nickel, palladium and zinc, it is preferred to adopt a strongly acidic cation-exchange resin having sulfonic acid group as a functional group. Examples of that resin include EG-290-HG ([trademark], manufactured by Organo Corporation), which is preferably used in the present invention.

The ion-exchange resin is generally swollen with a solvent when used. In that case, it is preferred that the swelling solvent be successively changed in the order of super pure water, isopropanol and the solvent used for the composition and thereafter that the ion exchange be carried out with the flow rate kept at room temperature. According to necessity, the ion-exchange resin is preferably subjected to preliminary washing with a solvent containing sulfuric acid, hydrochloric acid or nitric acid in a content of 5 to 98%, so as to reduce sodium or iron ions in the cation-exchange resin.

In order to lower the content of metal ions, it is also possible to adopt materials containing the metal ion impurities in a very small amount and to avoid them being in contact with metal vessels or pipes in the production process.

There are no particular restrictions on how to measure the content of metal ions in the polymer. However, since the polymer employed in the present invention contains the metals in a very small amount, the metal content is preferably measured by inductively coupled plasma mass spectroscopy.

It is not completely revealed why the above polymer enables the composition for producing a sacrifice layer to have excellent storage stability, but the reason is presumed to be as follows.

In general industrial processes for manufacturing various polymers, metal-made vessels and pipes are normally used. Although some reaction vessels and mixing containers have glass-coated inner surfaces, it is virtually inevitable that materials and products are brought into contact with metal equipment. As a result, the products tend to be contaminated with a small amount of powdery metals or metal ions.

Further, in general, when organic substances are synthesized, metal-containing catalysts are often employed. Also for the polymer used in the present invention, the metal-containing catalysts are employed so as to improve the reaction efficiency or yield. Those catalysts often contain transition metals, such as, iron, copper, vanadium, nickel, palladium and zinc, and consequently the produced polymer is liable to contain those metal ions. When, in particular, an oxidative coupling polymerization, which is very useful, is carried out, the metal-containing catalysts are used in a relatively large amount. Accordingly, polymers obtained by that polymerization are generally likely to contain large amounts of metal ions. Because of that, if the polymer is synthesized by the oxidative polymerization, reduction of the metal ions tends to make the effect of the present invention appear remarkably.

If the polymer containing a large amount of metal ions is employed to prepare a composition, the obtained composition contains the polymer together with the metal ions. In that case, if the polymer includes a nitrogen atom with a lone pair, the lone pair may form a coordinate bond between the nitrogen atom and the metal ion. As a result, the polymer is thought to aggregate easily enough to form fine particles. The nitrogen atom is apt to combine readily with particular metal ions, which are iron, copper, vanadium, nickel, palladium and zinc, and therefore formation of the fine particles is thought to be enhanced if those ions are present. This is the reason why the remarkable effect of the present invention can be achieved by reducing those transition metal ions. It is noted that this effect appears only when a particular polymer is used. For example, such a conventional composition for producing a sacrifice layer as comprises polystyrene or the like has only a small effect of reducing the metal ions, and further polystyrene is unfavorable in view of the heat resistance, as described above.

### [methods for forming air gaps among wirings and for producing a semiconductor device]

In the methods of the present invention for forming air gaps among wirings and for producing a semiconductor device, materials beforehand provided with gaps, pores, grooves and other concave areas are protected during processing steps for producing the semiconductor device. Those materials are generally referred to as "porous materials" in the present invention. The present invention is applied to materials of low permittivity, and most of them are porous materials containing plural pores. Specifically, those porous materials have low densities and accordingly tend to suffer from physical or chemical damages when, for example, subjected to dry-etching. Further, the materials containing dispersed pores have surfaces on which concavities and the like attributed to the pores. On those surfaces, the edge parts tend to suffer from physical or chemical damages as compared with the flat areas. The second method of the present invention prevents those damages. The method will be explained below with reference to the accompanying drawings.

First, a composition 101 for producing a sacrifice layer is applied to coat the surface of a porous material 100 (Figure 1(A)). Examples of the porous material include silicon dioxide and polyamide. The size and ratio of pores or gaps formed in the porous material depend on the performance of the aimed semiconductor device, but the average pore diameter is generally 100 nm or less, preferably 40 nm or less. The gap ratio is generally 5 to 70%, preferably 5 to 50%. Here, the average pore diameter can be measured by observation with a transmission electron microscope (TEM), and the gap ratio can be obtained by calculation from the permittivity according to the logarithmic mixture rule.

The composition applied on the surface of the porous material 100 gradually penetrates thereinto to fill the gaps with the passage of time. However, the penetration can be accelerated by heating or pressing, preferably by heating. When heated to raise the temperature, the composition becomes less viscous and hence is promoted to penetrate into the gaps. The solvent used in the composition is preferably selected from the viewpoints of the coating properties and the penetrability.

After the composition is sufficiently penetrated into the porous material 100, a part or all of the solvent in the composition is vaporized by heating or the like so as to solidify and thereby convert the composition in the gaps into a sacrificial material 101A. Thereafter, the sacrificial material appearing on the surface is then removed, if necessary, to obtain a porous material in which the gaps are filled with the sacrificial material (Figure 1(B)). Those filled gaps play the role of sacrifice areas.

Subsequently, the porous material is subjected to surface-processing of plasma etching or dry etching to form concave areas such as grooves 103 (Figure 1(C)). The plasma etching or dry etching in this step is carried out under the conditions different from those of plasma treatment carried out later for removing the sacrificial material. Specifically, if the porous material is made of silicon dioxide, it is general to use CF₄, CHF₃ or a mixed gas thereof in dry etching. In this procedure, since the gaps are filled with the sacrificial material in the present invention, the whole material has such high mechanical strength as to suffer less damage from lithographic treatment, plasma etching or dry etching.

After the plasma or etching treatment, the grooves 103 are filled with a metal material by, for example, chemical vapor deposition to form metal wirings. Subsequently, the sacrificial material is then selectively removed. There are no particular restrictions on the process for selectively removing the sacrificial material. For example, this procedure is preferably carried out in a manner where the material is decomposed by heating and thereby removed, where the material is removed by plasma treatment, where the material is removed by dissolving in a solvent, or where the material is removed by exposing to high-energy radiation. It is particularly preferred to remove the sacrificial material by heating. For example, the whole porous material is heated so that the sacrificial material 101A filling the gaps can be decomposed, vaporized and thereby removed (Figure 1(C)). As a result, the sacrifice areas are converted back into hollow gaps 104. In this way, it is possible to obtain a surface-treated porous material without suffering damage from plasma etching or dry etching. Semiconductor devices manufactured by use of those undamaged porous materials have small amounts of defects, and hence can be produced in high productivity.

In the method for producing a semiconductor device, the composition for producing a sacrifice layer is preferably excellent both in the coating properties and in the permeability into the porous material. In view of that, it is preferred to adopt a nonpolar solvent, such as MIBK, as the solvent. Also, for the purpose of keeping favorable permeability of the composition, it is possible to control the molecular weight of the polymer in the composition. Specifically, the polymer has a weight average molecular weight of generally 1000 to 150000, preferably 1500 to 50000. Further, it is preferred that the polymer not be decomposed and vaporized during plasma etching or dry etching but be completely decomposed and vaporized when heated thereafter. The conditions of the plasma etching or dry etching and the temperature of heating are variously controlled according to various reasons, and hence at what temperature the sacrificial material is decomposed and vaporized is also variously controlled according to them. However, it is generally preferred that the sacrificial material not be substantially decomposed and vaporized, for example, at 400°C but be substantially completely decomposed and vaporized, for example, at 600°C. Specifically, the sacrificial material reduces the weight by preferably 5% or less, further preferably 3% or less when heated at 400°C for 1 hour, but by preferably 80% or more, further preferably 90% or more when heated at 600°C for 1 hour. The solid content in the composition of the present invention mostly consists of the above polymer, and hence the sacrificial material provided by the composition is virtually composed of the above polymer. Accordingly, the weight loss of the sacrificial material essentially corresponds to that of the polymer.

The present invention will be further explained in detail by Examples described below, but is by no means limited to them. Unless specifically stated otherwise in the following description, "part(s)" means "weight part(s)". Further, tests and evaluations were carried out in the following manners.

### [molecular weight]

The number average molecular weight (Mn), weight average molecular weight (Mw) and molecular-weight distribution (Mw/Mn) of the polymer were measured by gel permeation chromatography (GPC) in terms of polystyrene reduced value.

### [verification of whether or not the polymer composition was filled in porous SiO₂ and of whether or not air gaps are formed]

In order to verify whether or not the polymer was filled and whether or not air gaps were formed, the refractive index at 633 nm was measured with a spectroscopic ellipsometer to observe the change thereof.

### [weight loss]

The weight loss of each sample was measured by thermogravimetry (TG) under the condition where the sample was heated to 400°C or 600°C at a rate of 20°C/minute and kept at the temperature for 1 hour in an atmosphere of nitrogen or air.

### [amount of metals]

The contents (ppb) of iron, copper, vanadium, nickel, palladium and zinc ions in the composition were measured by inductively coupled plasma mass spectroscopy (ICP-MS).

### [amount of fine particles]

The amount of fine particles having sizes of 0.2 µm or more in the composition (psc/ml) was measured with a liquid particle counter (LPC). According to the result, the composition showing 40 pcs/ml or less was graded as "good" while that showing more than 40 pcs/ml was graded as "poor."

### [number of defects]

The number of defects was measured by means of a defect detection system (KLA2351 [trademark], manufactured by KLA-Tencor Corporation). Specifically, the composition was applied to form a film on an 8-inch wafer, and then defects formed on the surface were detected with the system. According to the result, the composition showing 30 numbers/wafer or less was graded as "good" while that showing more than 30 numbers/wafer was graded as "poor."

### [polymer synthesis example 1]

### (synthesis of poly-4-methyltriphenyleneamine (Polymer P1))

Iron(III) chloride (anhydrous) (519 parts) and chloroform (4330 parts) were mixed under a nitrogen atmosphere in a reaction vessel equipped with a stirrer, a condenser, a heater, a nitrogen-introduction tube and a thermostat, and the reaction temperature was kept at 50°C. Subsequently, 4-methyltriphenylamine (212 parts) dissolved in chloroform (440 parts) was added and stirred. The reaction temperature was kept at 50°C for 0.5 hour to proceed the reaction (oxidative coupling polymerization).

After the reaction was completed, the reaction solution was poured into acetone (54000 parts) and then precipitate was collected by filtration. The precipitate was dissolved in chloroform (4000 parts), and insoluble residue was removed by filtration. To the filtrate, 1 wt% aqueous ammonia solution (4000 parts) was added and the chloroform solution was extracted. Subsequently, the chloroform solution was condensed and poured into acetone (54000 parts) and then precipitate was collected by filtration. The collected precipitate was dried in vacuum at 90°C, to obtain Polymer P1 in an amount of 85 parts (yield: 40%). The molecular weight thereof was then measured by GPC to obtain the following results: number average molecular weight Mn =2170 Da,
weight average molecular weight Mw = 3991 Da, and molecular-weight distribution Mw/Mn =1.84.

### [polymer synthesis example 2]

### (synthesis of poly-methyldiphenyleneamine (Polymer P2))

The procedure of synthesis example 1 was repeated except for changing the monomer from 4-methyltriphenylamine to methyldiphenylamine.

### [weight loss evaluation of Polymer P1]

Cyclohexanone (275 parts) was added to Polymer P1 (10 parts), and the mixture was stirred for 30 minutes at room temperature to prepare a 3.5 wt% polymer composition.

The prepared polymer composition was applied on a porous Si-wafer by spin-coating, and heated at 150°C for 5 minutes on a vacuum hot plate in a nitrogen atmosphere, to obtain a polymer film. The weight loss of the polymer film was measured in the manner described above, and as a result, it was found that the film reduced the weight by 0.03% and 99.23% when heated (in an atmosphere of air) for 1 hour at 400°C and 600°C, respectively.

### [weight loss evaluation of Polymers P2 to P8]

The polymers shown in Table 1 was prepared. With respect to each polymer, an appropriate solvent was selected to produce a polymer composition. The weight loss of each composition was evaluated, and the results are shown in Table 1.

**[Table 1]**

| Table 1 | Evaluation of polymers | | | | | | | | |
|---|---|---|---|---|---|---|---|---|---|
| Polymer | | | | | Solvent | Weight loss (%) | | | |
| Kind of polymer | | Mn | Mw | Mw/Mn | | 400°C | | 600°C | |
| | | | | | | N₂ | Air | N₂ | Air |
| P1 | polymer synthesis example 1 | 2170 | 3991 | 1,84 | cyclohexanone | - | 0,03 | - | 99,23 |
| P2 | polymer synthesis example 2 | 1990 | 3701 | 1,86 | cyclohexanone | - | 0,05 | - | 99,53 |
| P3 | polyaniline | 2300 | 5020 | 2,18 | toluene | - | 0.10 | - | 99,04 |
| P4 | poly/ethyleneimine) | 5013 | 5915 | 1,18 | ethyl lactate | 3,45 | - | 99,98 | - |
| P5 | poly/2-ethyl-2-oxazoline) | 83994 | 530120 | 6,31 | ethyl lactate | 1,91 | - | 99,89 | - |
| P6 | polyacrylamide | 40060 | 100551 | 2,51 | DMF*¹ | 2,51 | - | 0,11 | - |
| P7 | polynonamethyleneterephthalamide | 8049 | 20043 | 2,49 | DMF*¹ | - | 0,04 | - | 99.19 |
| P8 | polystyrene | 137600 | 144480 | 1,05 | PGMEA*² | 4,34 | 15,61 | 99,97 | 99,96 |
| Polymers P2 to P5 are available from Sigma-Aldrich Inc. and Polymer P6 is from Kuraray Co., Ltd. | | | | | | | | | |
| *1: N,N-dimethylformamide | | | | | | | | | |
| *2: propyleneglycol monomethyl ether acetate | | | | | | | | | |

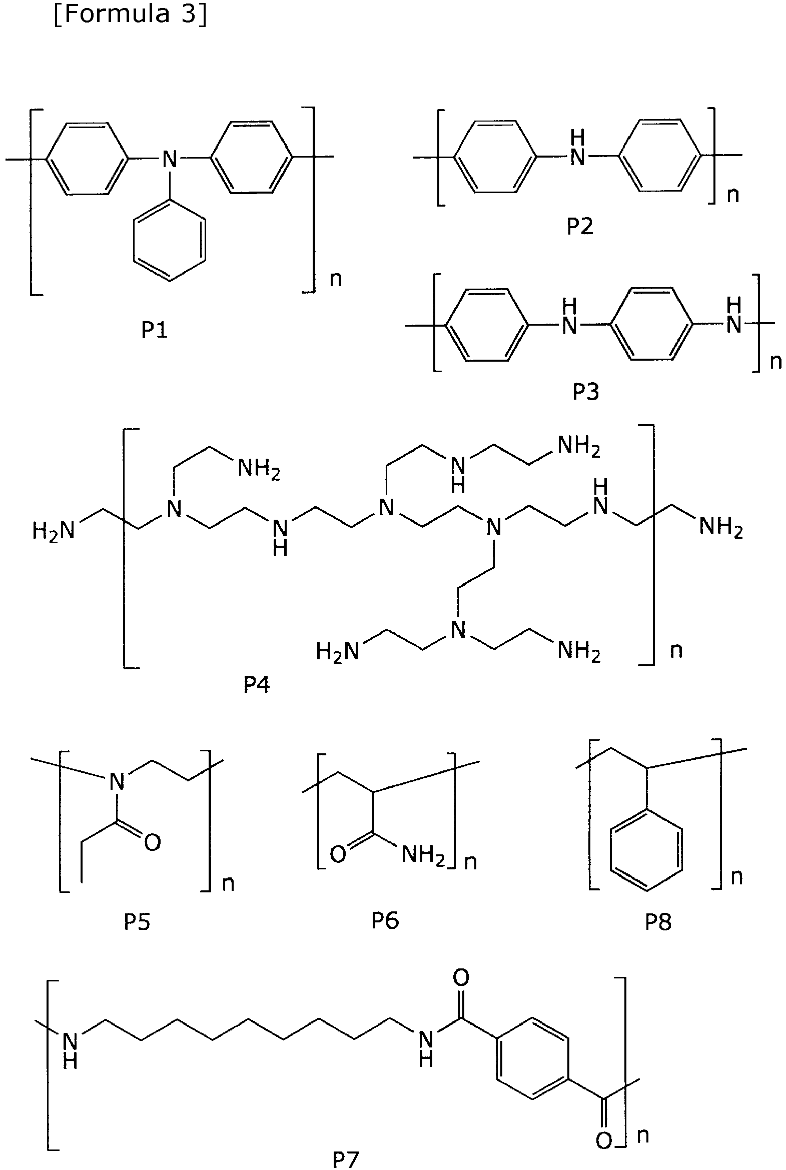

### [Example 1]

Cyclohexanone (275 parts) was added to Polymer P1 (10 parts), and the mixture was stirred for 30 minutes at room temperature to prepare a 3.5 wt% polymer composition. Independently, a glass column was charged with an ion-exchange resin (EG-290-HG [trademark], manufactured by Organo Corporation) beforehand substituted with cyclohexanone. Subsequently, the polymer composition was made to flow through the column, and then further filtrated through a 10 nm-pore filter to obtain a composition 1A for producing a sacrifice layer. The contents of transition metal ions contained in the composition 1A were quantitively analyzed by means of an inductively coupled plasma mass spectrometer. Further, the composition was stored at room temperature, and then repeatedly subjected to the measurements of fine particles and defects immediately after, 10 days after, 30 days after and 60 days after preparation. The results are shown in Table 2.

For the purpose of measuring the defects, the composition was applied on an 8-inch Si-wafer and then heated at 330°C for 5 minutes on a hot plate in a nitrogen atmosphere to produce a sample wafer for the defect measurement.

### [Comparative example 1]

Cyclohexanone (275 parts) was added to Polymer P1 (10 parts), and the mixture was stirred for 30 minutes at room temperature to prepare a 3.5 wt% polymer composition, which was then filtrated through a 10 nm-pore filter to obtain a polymer composition 1B for producing a sacrifice layer. With respect to the composition 1B, the procedure of Example 1 was repeated to measure the contents of transition metal ions, the amount of fine particles and the number of defects. The results are shown in Table 2.

### [Examples 2 to 8 and Comparative examples 2 to 8]

The components of the polymer composition were changed as shown in Table 2, to prepare the composition of each example. As for each of the compositions, the contents of transition metal ions, the amount of fine particles and the number of defects were measured, and the results are shown in Table 2.
[Table 2]

**Table 2 Evaluation of the metal contents, the amount of fine particles and the number of defects in the composition**

| | Composition | | | | Ion content (ppb) | | | | | | | Fine particles of 0.2 *µ* m (pcs/ml) | | | | Defects (numbers/wafer) | | | |
|---|---|---|---|---|---|---|---|---|---|---|---|---|---|---|---|---|---|---|---|
| | Polymer | Polymer content (%) | Solvent | Ion exchange | Fe | Cu | V | Ni | Pd | Zn | Total | Immediately after prepared | After 10 days | After 30 days | After 60 days | Immediately after prepared | After 10 days | After 30 days | After 60 days |
| Ex. 1 | P1 | 3.5 | cyclohexa-none | done | 0.5 | 0.2 | 0.1 | 0.2 | 0.2 | 0.3 | 1.5 | 4 (good) | 4 (good) | 5 (good) | 5 (good) | 5 (good) | 5 (good) | 6 (good) | 6 (good) |
| Ex. 2 | | 8.5 | | done | 1.1 | 0.1 | 0.2 | 0.4 | 0.3 | 0.2 | 2.3 | 5 (good) | 5 (good) | 5 (good) | 7 (good) | 4 (good) | 7 (good) | 7 (good) | 7 (good) |
| Com. 1 | | 3.5 | | not | 3.1 | 0.2 | 0.4 | 0.4 | 0.2 | 0.7 | 5.0 | 4 (good) | 80 (poor) | 123 (poor) | 176 (poor) | 6 (good) | 52 (poor) | 101 (poor) | 1021 (poor) |
| Ex. 3 | P2 | 3.5 | cyclohexa-none | done | 0.4 | 0.2 | 0.1 | 0.3 | 0.2 | 0.2 | 1.2 | 4 (good) | 4 (good) | 5 (good) | 5 (good) | 3 (good) | 4 (good) | 5 (good) | 5 (good) |
| Com. 2 | | 3.5 | | not | 5.1 | 0.2 | 0.2 | 0.3 | 0.2 | 0.4 | 6.4 | 5 (good) | 82 (poor) | 137 (poor) | 198 (poor) | 5 (good) | 42 (poor) | 98 (poor) | 1510 (poor) |
| Ex. 4 | P3 | 3.5 | toluene | done | 0.9 | 0.5 | 0.3 | 0.6 | 0.1 | 0.2 | 2.6 | 9 (good) | 9 (good) | 10 (good) | 10 (good) | 4 (good) | 6 (good) | 7 (good) | 7 (good) |
| Com. 3 | | 3.5 | | not | 0,2 | 0.2 | 0.1 | 6.2 | 0.4 | 0.1 | 7.2 | 5 (good) | 25 (good) | 50 (poor) | 59 (poor) | 4 (good) | 12 (good) | 61 (poor) | 1230 (poor) |
| Ex. 5 | P4 | 3.5 | ethyl lactate | done | 1.9 | 0.4 | 0.2 | 0.1 | 0.1 | 0.1 | 2.8 | 7 (good) | 8 (good) | 8 (good) | 10 (good) | 5 (good) | 6 (good) | 7 (good) | 7 (good) |
| Com. 4 | | 3.5 | | not | 0.6 | 6.8 | 0.5 | 0.4 | 0.2 | 1.2 | 9.7 | 11 (good) | 10 (good) | 27 (good) | 52 (poor) | 6 (good) | 8 (good) | 21 (good) | 640 (poor) |
| Ex. 6 | P5 | 3.5 | ethyl lactate | done | 1.1 | 0.3 | 0.1 | 0.2 | 0.3 | 0.2 | 2.2 | 4 (good) | 4 (good) | 6 (good) | 6 (good) | 3 (good) | 4 (good) | 8 (good) | 8 (good) |
| Com. 5 | | 3.5 | | not | 1.1 | 0.5 | 0.4 | 0.7 | 6.2 | 0.8 | 9.7 | 9 (good) | 17 (good) | 32 (good) | 56 (poor) | 5 (good) | 5 (good) | 29 (poor) | 1170 (poor) |
| Ex. 7 | P6 | 3.5 | DMF | done | 0.9 | 0.5 | 0.2 | 0.4 | 0.1 | 0.2 | 2.3 | 4 (good) | 7 (good) | 8 (good) | 8 (good) | 7 (good) | 8 (good) | 10 (good) | 10 (good) |
| Com. 6 | | 3.5 | | not | 0.8 | 0.4 | 0.2 | 0.6 | 0.2 | 4.9 | 7.1 | 5 (good) | 19 (good) | 57 (poor) | 101 (poor) | 4 (good) | 6 (good) | 66 (poor) | 1410 (poor) |
| Ex. 8 | P7 | 3.5 | DMF | done | 1.2 | 0.3 | 0.5 | 0.2 | 0.2 | 0.4 | 2.8 | 9 (good) | 11 (good) | 12 (good) | 12 (good) | 6 (good) | 8 (good) | 8 (good) | 8 (good) |
| Com. 7 | | 3.5 | | not | 0.2 | 0.8 | 5.1 | 0.1 | 0.3 | 0.6 | 7.1 | 6 (good) | 27 (good) | 68 (poor) | 87 (poor) | 5 (good) | 13 (good) | 123 (poor) | 1830 (poor) |
| Com. 8 | P8 | 3.5 | PGMEA | not | 7.2 | 0.3 | 0.4 | 0.2 | 0.1 | 0.1 | 8.3 | 2 (good) | 2 (good) | 2 (good) | 3 (good) | 4 (good) | 5 (good) | 6 (good) | 6 (good) |

The composition of Example 1 for producing a sacrifice layer was applied on the surface of a porous SiO₂ wafer, and then heated at 330°C on a hot-plate for 5 minutes in a nitrogen atmosphere, so that pores in the wafer were filled with the composition. Subsequently, the wafer was rinsed with cyclohexanone, which was a solvent of the composition, for 20 second, to remove excess of the composition remaining on the surface. The wafer was then observed with a spectroscopic ellipsometer, to find that the refractive index (n value) at 633 nm was 1.46. Further, after the wafer was heated at 400°C for 1 minutes in air, the refractive index (n value) at 633 nm was measured and found to be 1.46. The wafer was furthermore heated at 600°C for 1 hour in air, and then the refractive index (n value) at 633 nm was again measured and found to be 1.31. This refractive index (n value) was the same as that of the untreated porous wafer, and hence it was verified that the composition filling the pores was decomposed by heating at 600°C for 1 hour.

### [weight loss and gap-formation effect evaluation of Polymers P2 to P8]

With respect to each of Examples 3 to 8 and Comparative example 8, the composition for producing a sacrifice layer was evaluated in the same manner as that of Example 1, to evaluate the gap-formation effect. The results are shown in Table 3.
[Table 3]

**Table 3 Evaluation of refractive index in use of composition for gap-formation**

| | Composition | | | | Refractive index | | | | | |
|---|---|---|---|---|---|---|---|---|---|---|
| | polymer | polymer content (%) | solvent | Ion exchange | Heating conditions | | | | | |
| | | | | | unheated | 330°C | 400°C | | 600°C | |
| | | | | | | nitrogen | nitrogen | air | air | nitrogen |
| Reference | porous SiO₂ wafer | | | | 1.31 | | | | | |
| Ex. 1 | P1 | 3.5 | cyclohexanone | done | - | 1.46 | - | 1.46 | - | 1.31 |
| Ex. 3 | P2 | 3.5 | cyclohexanone | done | - | 1.46 | - | 1.45 | - | 1.32 |
| Ex. 4 | P3 | 3.5 | toluene | done | - | 1.46 | - | 1.45 | - | 1.31 |
| Ex. 5 | P4 | 3.5 | ethyllactate | done | - | 1.41 | 1.41 | - | 1.31 | - |
| Ex. 6 | P5 | 3.5 | ethyllactate | done | - | 1.43 | 1.42 | - | 1.32 | - |
| Ex. 7 | P6 | 3.5 | DMF | done | - | 1.44 | 1.43 | - | 1.31 | - |
| Ex. 8 | P7 | 3.5 | DMF | done | - | 1.45 | - | 1.45 | - | 1.32 |
| Com. 8 | P8 | 3.5 | PGMEA | not | - | 1.46 | 1.39 | 1.33 | 1.32 | 1.31 |

The compositions containing Polymers P2 to P7 (Examples 3 to 8) were also confirmed not to decompose at 400°C but to decompose at 600°C. On the other hand, the composition containing Polymer P8, which included no lone pair, was found to start decomposing already at 400°C (Comparative example 8).

### DESCRIPTION OF THE NUMERALS

- 100:: porous material,
- 101:: composition for producing a sacrifice layer,
- 101A:: sacrifice area,
- 103:: groove,
- 104:: air gap

## Claims

1. A composition for producing a sacrifice layer, comprising a solvent and a polymer having a repeating unit containing a nitrogen atom with a lone pair, wherein said composition contains transition metals in a total content of 3.0 ppb or less.

2. The composition for producing a sacrifice layer according to claim 1, which contains iron, copper, vanadium, nickel, palladium and zinc in a total content of 3.0 ppb or less.

3. The composition for producing a sacrifice layer according to claim 1 or 2, wherein said nitrogen atom is included in an amino or imino group.

4. The composition for producing a sacrifice layer according to any of claims 1 to 3, wherein said repeating unit is selected from the group consisting of the following formulas (1) to (4): 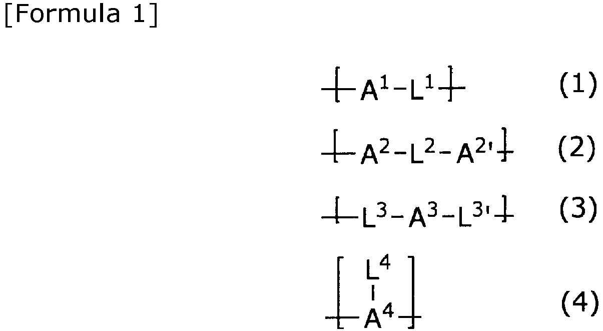 in which
each of A¹, A², A^{2'}, A³ and A⁴ is independently an aromatic group or a saturated or unsaturated aliphatic hydrocarbon group, provided that said aromatic group or aliphatic hydrocarbon group may be substituted with a substituent selected from the group consisting of hydroxyl, alkyl, aryl, alkoxy, nitro, amide, dialkylamino, sulfonamide, imide, carboxy, sulfonic ester, alkylamino and arylamino;
each of L¹, L², L³ and L^{3'} is independently selected from the group consisting of the following formulas (a1) to (a3): 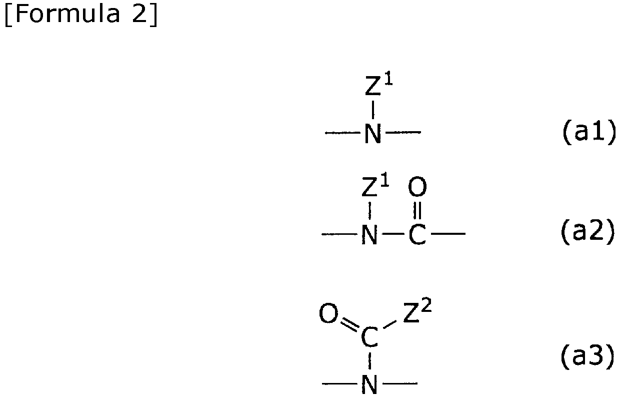 in which
Z¹ is selected from the group consisting of hydrogen, an aliphatic group and an aromatic group, provided that said aliphatic or aromatic group is selected from the group consisting of alkyl, aryl, alkoxy, nitro, amide, dialkylamino, sulfonamide, imide, carboxy, sulfonic ester, alkylamino and arylamino;
Z² is selected from the group consisting of hydrogen, hydroxyl, an aliphatic group and an aromatic group, provided that said aliphatic or aromatic group is selected from the group consisting of alkyl, aryl, alkoxy, nitro, amide, dialkylamino, sulfonamide, imide, carboxy, sulfonic ester, alkylamino and arylamino; and
L⁴ is selected from the group consisting of amino group, carbamoyl group, and substituted aromatic and aliphatic groups including them as substituents.

5. The composition for producing a sacrifice layer according to claim 4, wherein
each of said A¹, A² and A^{2'} is independently selected from the group consisting of phenylene and naphthylene groups, and
said Z¹ is selected from the group consisting of hydrogen, phenylene and naphthylene groups.

6. The composition for producing a sacrifice layer according to claim 4, wherein
each of said A¹, A² and A^{2'} is independently selected from the group consisting of an alkylene group having 1 to 6 carbon atoms and an alkenylene group having 2 to 6 carbon atoms, and
each of said Z¹ and Z² is independently selected from the group consisting of hydrogen, an alkyl group having 1 to 10 carbon atoms, a cycloalkyl group having 3 to 10 carbon atoms, an alkenyl group having 2 to 10 carbon atoms, a cycloalkenyl group having 3 to 10 carbon atoms, an aryl group having 6 to 10 carbon atoms, and a cyclic amine group having 2 to 5 carbon atoms.

7. The composition for producing a sacrifice layer according to claim 4, wherein
said A⁴ is selected from the group consisting of a saturated hydrocarbon group having 1 to 6 carbon atoms and an unsaturated hydrocarbon group having 2 to 6 carbon atoms, and
said L⁴ is selected from the group consisting of a saturated or unsaturated amino group, a saturated or unsaturated carbamoyl group, and a hydrocarbon group substituted therewith.

8. The composition for producing a sacrifice layer according to claim 4, wherein
said A³ is selected from the group consisting of a saturated hydrocarbon group having 1 to 12 carbon atoms and an unsaturated hydrocarbon group having 2 to 12 carbon atoms, and
said L³ is selected from the group consisting of -(NH)-and -(NH)-(C=O)-.

9. The composition for producing a sacrifice layer according to any of claims 1 to 8, wherein said polymer has a weight average molecular weight of 1000 to 1000000.

10. The composition for producing a sacrifice layer according to any of claims 1 to 9, which comprises said polymer in a content of 0.2 to 20 wt% based on the total weight of the composition.

11. The composition for producing a sacrifice layer according to any of claims 1 to 10, wherein said polymer reduces the weight by 5% or less and by 80% or more when heated at 400°C for 1 hour and at 600°C for 1 hour, respectively, in an atmosphere of an inert gas or air.

12. The composition for producing a sacrifice layer according to any of claims 1 to 11, which is produced in a manner where said solvent and said polymer are mixed and dissolved to prepare a solution, from which transition metal ions are then removed.

13. A process for producing a composition for producing a sacrifice layer comprises:
preparing a solution by mixing a solvent and a polymer having a repeating unit containing a nitrogen atom with a lone pair and dissolving said polymer in the solvent, and
removing transition metal ions from the solution so that the total content of transition metals may be 3.0 ppb or less.

14. A process for producing a semiconductor device comprising a porous material containing plural air gaps, comprises:
applying said porous material with the composition for producing a sacrifice layer according to any of claims 1 to 12, so that said air gaps are filled with said composition,
vaporizing a part or all of the solvent in said composition to form sacrifice areas made of a sacrificial material,
forming grooves on the surface of said porous material,
filling said grooves with a metal material so as to form metal wirings, and
removing said sacrificial material selectively so as to convert said sacrifice areas back into hollow gaps.

15. A semiconductor device produced by the process according to claim 14.
